# EUROPEAN PATENT APPLICATION

(11) **EP 4 492 140 A1**
(43) Date of publication of application: **15.01.2025**
(21) Application number: 23184336.8
(22) Date of filing: 10.07.2023
(51) Int. Cl.: G03F 7/00, G01J 3/18, G01J 3/32

(54) **APPARATUS FOR WAVELENGTH-RESOLVED BEAM MONITORING**

(71) Applicant: ASML Netherlands B.V., 5500 AH Veldhoven (NL)
(72) Inventor: TUDOROVSKIY, Timur, Yakovlevich, 5500 AH Veldhoven (NL); VAN DER POST, Sietse, Thijmen, 5500 AH Veldhoven (NL); SMORENBURG, Petrus, Wilhelmus, 5500 AH Veldhoven (NL); O'DWYER, David, 5500 AH Veldhoven (NL); TAO, Yin, 5500 AH Veldhoven (NL); PLOEGMAKERS, Jeroen, Jos, 5500 AH Veldhoven (NL); JANSEN, Elmer, Wolter, 5500 AH Veldhoven (NL)
(74) Representative: ASML Netherlands B.V.

(57) **Abstract**

System an apparatus for wavelength resolved beam profiling. The apparatus comprises a beam monitoring assembly configured to receive a radiation beam comprising a plurality of wavelengths, and to provide a diffracted radiation of the plurality of wavelengths, wherein each of the plurality of wavelengths is spatially separated in the diffracted radiation. The apparatus comprises a color selector configured to select a portion of the diffracted radiation. The apparatus comprises a detector configured to detect the selected diffracted radiation and to generate beam profile data of the selected radiation. The color selector is movable to select each of the plurality of diffracted wavelengths of the diffracted radiation such that the plurality of wavelengths do not overlap when incident on the detector.

## Description

### FIELD

The present invention relates to systems and apparatus for wavelength resolved beam profiling. Specifically it relates to beam profiling for short wavelength radiation comprising a plurality of different wavelengths.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. Scatterometers can be used for example to control the process quality.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target. In order to obtain information about different layers in a lithographic stack, a monochromatic beam could be used and the metrology target rotated relative to the beam (an angularly-resolved spectrometer). In other applications a fixed sample can be used with a beam having multiple wavelengths (a spectroscopic spectrometer). Multi-color beam metrology may provide faster measurement, but at a cost of increased beam monitoring complexity.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump/drive radiation (e.g., infrared IR radiation) to excite a generating medium, thereby generating an emitted radiation, optionally a high harmonic generation comprising high frequency radiation.

There are several challenges to address when performing metrology using short wavelength radiation. This may for example be because standard optical elements and materials used in optical elements for longer wavelengths are not suitable to be used with short wavelength radiation. Another challenge may be that the properties of the beam itself (e.g. intensity, beam shape, etc.) may affect the measurements. A radiation beam may comprise multiple wavelengths, which may be discrete wavelengths. Each of the different wavelengths may have different properties, such as beam profile (e.g. intensity profile, beam shape, etc). Provided herein are apparatus and systems for metrology using multi-wavelength high frequency radiation.

### SUMMARY

According to a first aspect of the current disclosure, there is provided an apparatus comprising a beam monitoring assembly configured to receive a radiation beam comprising a plurality of wavelengths, and to provide a diffracted radiation of the plurality of wavelengths, wherein each of the plurality of wavelengths is spatially separated in the diffracted radiation. The apparatus further comprises a color selector configured to select a portion of the diffracted radiation, and a detector configured to detect the selected diffracted radiation and to generate beam profile data of the selected radiation. The color selector is movable to select each of the plurality of diffracted wavelengths of the diffracted radiation such that the plurality of wavelengths do not overlap when incident on the detector. The apparatus may be for wavelength-resolved beam profiling.

Optionally, the color selector may comprise a moveable slit.

Optionally, the color selector may comprise a moveable aperture.

Optionally, the slit or aperture may be apodised .

Optionally, the color selector may comprise a set of mirrors.

Optionally, the color selector may comprise a transmission grating with width-adjustable slits.

Optionally, the transmission grating is movable.

Optionally, the transmission grating may generate an interference pattern of the selected radiation, and wherein the detector detects the interference pattern.

Optionally, the diffracted wavelengths may be spatially separated in a first plane, and wherein the color selector is located in the first plane.

Optionally, the color selector may be configured to move in a single direction across the first plane.

Optionally, the first plane may be a first focal plane of at least one wavelength of the diffracted radiation.

Optionally, the first plane may be a conjugate plane of a generation plane of the radiation.

Optionally, the diffracted wavelengths may have different focal points. The color selector may move along the different diffracted wavelengths focal points.

Optionally, the beam monitoring assembly may comprise a focusing mirror system comprising a diffraction grating, configured to diffract a portion of the incident radiation beam to form the diffracted radiation.

Optionally, the beam monitoring assembly may comprise a beam splitter configured to receive a radiation beam incident upon it, and to direct a portion of the radiation beam to a diffraction grating for generating diffracted radiation.

Optionally, the detector may be a camera configured to measure shape and intensity of incident radiation. The camera may measure an intensity of the radiation.

Optionally, the detector may be located in the far field of the diffracted radiation.

Optionally, the diffracted radiation may comprise one diffraction order.

Optionally, the detector may be configured to generate beam profile data of each of the plurality of diffracted wavelengths when it is detected by the detector, and to provide the beam profile data of the plurality of diffracted wavelengths to be combined to generate a beam profile of the radiation beam.

Optionally, the beam profile data may be detected during use of the radiation beam for a metrology application.

Optionally, the beam profile data may be configured to be generated in a time scale in a range of 10 seconds to 5 minutes, or 30 seconds to 2 minutes, or 60 seconds to 90 seconds, or 75 seconds.

Optionally, the detector may be configured to provide the beam profile data to a radiation source of the radiation beam for making radiation beam adjustments.

Optionally, the detector may be configured to provide the beam profile data to a metrology apparatus.

Optionally, the radiation may comprise radiation with wavelengths in a range from 1 nm - 100 nm, or 1 nm - 50 nm, or 1 nm - 20 nm, or 10 nm - 20 nm, or 1 nm to 10 nm.

Optionally, the radiation may comprise a radiation beam with a diameter in a range of 20 µm - 50 µm, such as 40 µm.

According to another aspect of the current disclosure there is provided a system comprising an apparatus for wavelength resolved beam profiling as described above, a radiation source configured to provide the radiation beam comprising a plurality of wavelengths to the apparatus, and a processor configured to receive beam profile data from the apparatus. The processor is configured to determine adjustments to one or more settings of the radiation source, to make adjustments to the radiation beam.

Optionally, the processor may be further configured to receive metrology data obtained using radiation from the radiation source, and determine a metrology component of the metrology data based on the metrology data in combination with the beam profile data. The metrology component may be a sample response.

Optionally, determining the metrology component may comprise determining a signature of the radiation beam based on the beam profile data, and subtracting the signature of the radiation beam from the metrology data to obtain the metrology component of the metrology data.

According to another aspect of the current disclosure there is provided an apparatus comprising a moveable selector configured to receive a radiation beam comprising a plurality of wavelengths, and to select a portion of the radiation beam. The apparatus further comprises a diffracting element configured to receive at least some of the selected portion of the radiation beam incident upon it, and to diffract the incident radiation, and a detector configured to detect the diffracted radiation and to generate beam profile data of the selected radiation.

Optionally, the moveable selector may be configured to move through the radiation beam so as to select each portion of the radiation beam over time. The detector may be configured to generate beam profile data for each selected portion of the radiation beam, and to provide the beam profile data of each selected portion for construction of a beam profile of the radiation beam.

Optionally, the movable selector may comprise a slit.

Optionally, a center of the slit may be aligned to a center of the diffracting element.

Optionally, the moveable selector may be configured to move along a first direction such that the entire beam circumference is selected by the moveable selector over time.

Optionally, the diffracting element may comprise a diffraction grating on a mirror.

Optionally, the radiation may comprise soft-X-ray radiation.

According to another aspect of the current disclosure there is provided a metrology apparatus comprising a system or an apparatus as described above.

According to another aspect of the current disclosure there is provided an inspection apparatus comprising a system or an apparatus as described above.

According to another aspect of the current disclosure there is provided a lithographic apparatus comprising a system or an apparatus as described above.

According to another aspect of the current disclosure there is provided a litho cell comprising a system or an apparatus as described above.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of a system comprising an apparatus for wavelength-resolved beam profiling as described herein;
- Figure 9 depicts a schematic representation of a system comprising an apparatus for wavelength-resolved beam profiling as described herein;
- Figure 10 depicts a schematic representation an apparatus for wavelength-resolved beam profiling as described herein; and
- Figure 11 depicts a schematic representation of an apparatus for wavelength resolved beam profiling.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

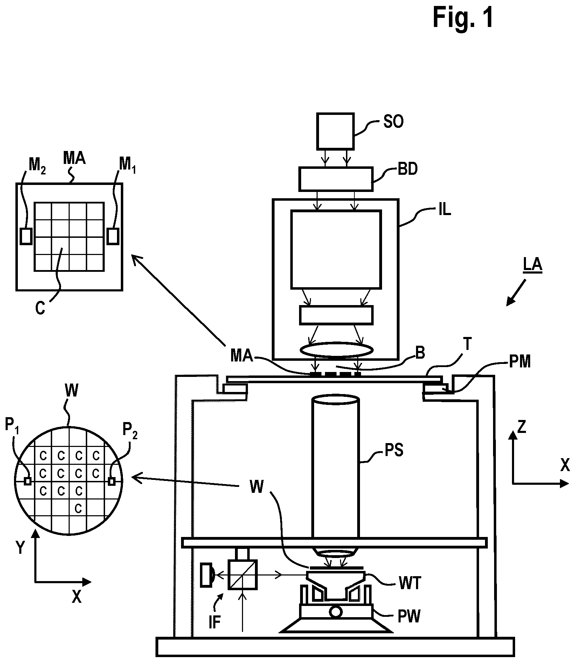

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

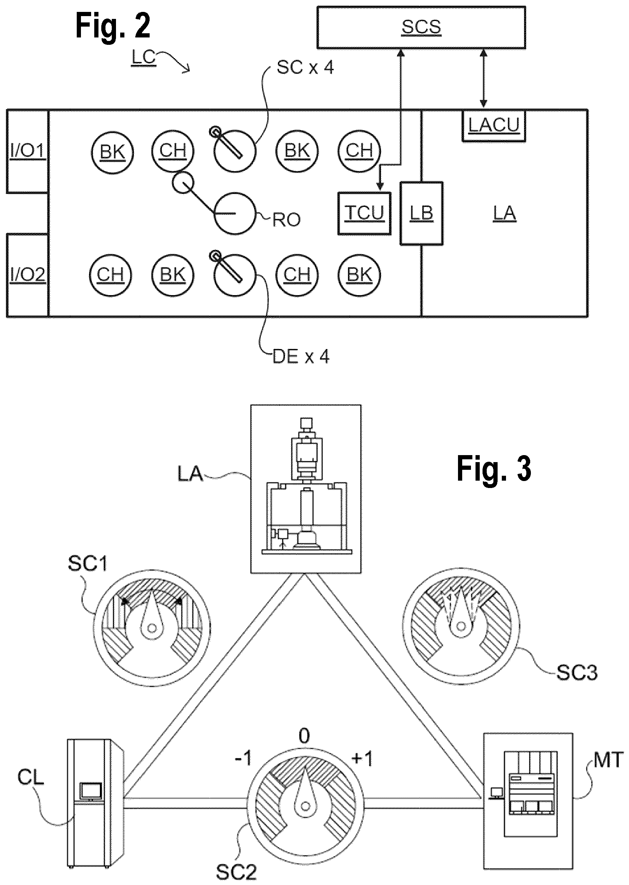

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

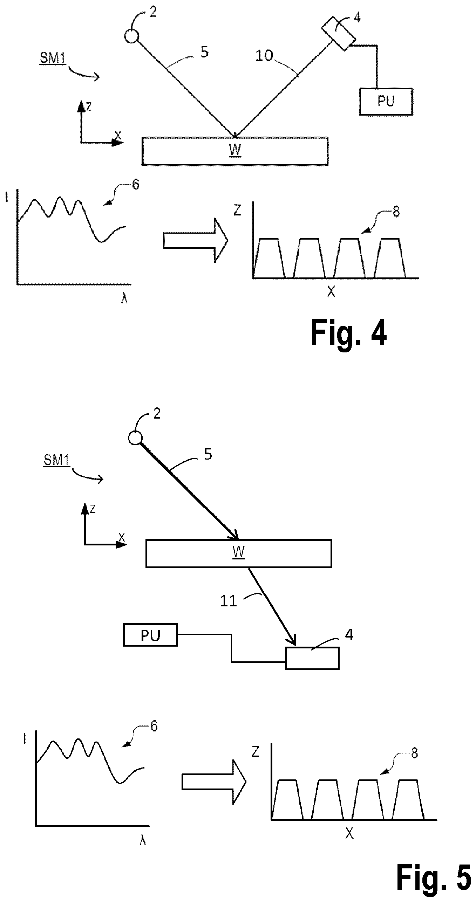

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1 nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

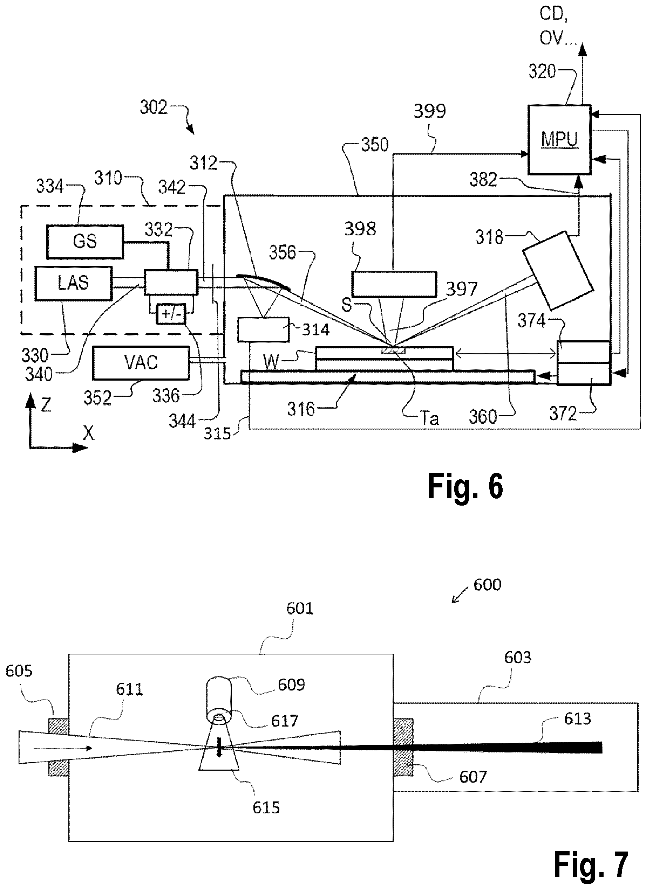

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump/drive radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus.The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of Interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump/drive radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a pump/drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

In one embodiment, the HHG radiation may comprise short wavelength radiation such as soft-X-ray radiation. The radiation may be generated to be provided in a metrology tool. The radiation may be broadband radiation. The broadband radiation may consist of a plurality of discrete wavelengths within a broadband range. Each of the wavelengths may have a different beam profile, such as different intensity profiles and/or different beam shapes. For optimal performance of the metrology tool, it may be advantageous to know the beam profile for each of the wavelengths in the radiation beam. This information may for example be obtained by measuring the beam profile for each of the wavelengths independently. Determining beam profiles for the different wavelengths of the radiation beam may be referred to as color-resolved beam profiling.

Resolving beam profiles for different wavelengths in a radiation beam may be required for sample reconstruction measured by the radiation beam. A sample reconstruction may be performed to determine one or more properties of a measured sample by analysing radiation that has interacted with the sample. In order to reconstruct a sample, the features in the measurement data that result from the radiation and/or the optical elements may be separated from the features resulting from the sample.

The sample may also be referred to as a target, or a metrology target. A metrology target may diffract every wavelength to a different location on the target, forming a spot. The shape of each spot may inherit properties of the incident wavelength. Shape information may be important to deconvolve a sample response from beam properties in the measured radiation. The sample response may be referred to as a metrology component of the measurement data. The shape information may be comprised within a radiation source signature present in the measurement data.

The broadband radiation may comprise a plurality of discrete wavelengths of significant intensity. In between these discrete wavelengths with peak intensities, radiation of other wavelengths may be present at a lower intensity. Determining of the beam profile data may be limited to determining a beam profile for the peak wavelengths. Peak wavelengths may for example be the central wavelength of an intensity peak above a predetermined threshold.

Short wavelength radiation may be required for measurements to achieve a resolution that is high enough to resolve the features of the metrology target. Short wavelengths, such as soft-X-ray (SXR) radiation may be sensitive to tiny aberrations present in the drive radiation (e.g. drive laser radiation). SXR beam metrology may be used to help optimise the wavefront of the radiation. The correspondence between SXR beam quality and drive radiation aberrations may be wavelength-dependent. Therefore, wavelength-resolved metrology may be required for drive radiation optimization. Wavelength-resolved metrology may also be referred to as color-resolved metrology.

SXR radiation can be focussed into a small spot on the target substrate/wafer. The spot radius for measurements on the substrate may for example be smaller than 10µm. To reach this target spot size, the beam profile may need to be optimized for all wavelengths in the radiation.

Technologies already exist to perform wavelength-resolved beam profile measurement. These technologies include for example ptychography, spectroscopic Hartman sensors, masks with holes filled by transmission gratings, and spectral wavefront optical reconstructions by diffraction. These techniques may all have disadvantages for use in lithographic and metrology applications as described herein. Ptychography may require extensive scanning with a scattering mask, which may take several hours. It may also require long numerical computations, which may take up to a day. The accuracy of a spectroscopic Hartman sensor may be diffraction-limited. Using small holes in a mask may lead to a low photon flux leading to long integration times on the detector. Described herein are improved methods for wavelength-resolved beam profile measurements.

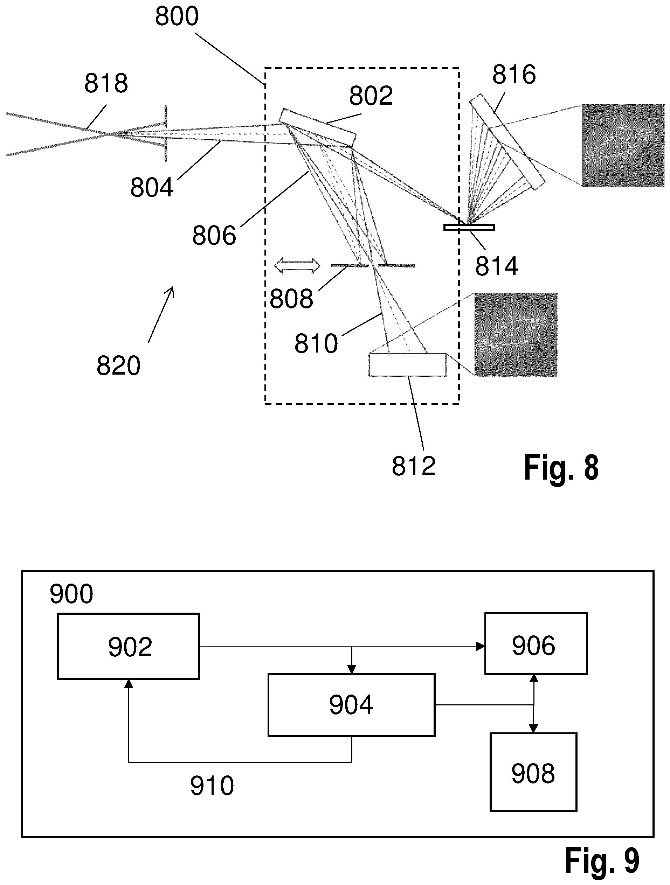

Figure 8 depicts a schematic representation of one embodiment of this invention, which is an apparatus 800 for wavelength-resolved beam profiling. The apparatus 800 comprises a beam monitoring assembly 802 configured to receive a radiation beam 804 comprising a plurality of wavelengths. The beam monitoring assembly 802 is also configured to provide diffracted radiation 806 of the plurality of wavelengths, wherein each of the plurality of wavelengths is spatially separated in the diffracted radiation. The apparatus 800 further comprises a selector, optionally a color selector, 808 configured to select a portion 810 of the diffracted radiation 806. The apparatus 800 further comprises a detector 812 configured to detect the selected diffracted radiation 810 and to generate beam profile data of the selected radiation 810. Optionally the color selector 808 is movable to select each of the plurality of diffracted wavelengths of the diffracted radiation such that the plurality of wavelengths to do not overlap when incident on the detector 812. Optionally the color selector 808 is movable to select part of the plurality of diffracted wavelengths of the diffracted radiation such that the overlap on the detector 812 is suppressed.

The apparatus 800 may form part of a system 820, as described in more detail below. The system may for example comprise a metrology setup for measuring a sample. The system may comprise some or all of the elements shown in figure 8, including a sample 814 (and stage for received the sample). The sample may be configured to receive an illumination portion of the radiation beam 804. A metrology detector 816 receives radiation from the sample for measurement of the sample. Drive radiation 818 used to generate the broadband radiation 804 is also shown.

An advantage of an apparatus as described above may be that it enables real-time monitoring of radiation that may contemporaneously may be used in a metrology application. A portion of broadband radiation used for wavelength-resolved profiling may be reflected or otherwise separated into a reference branch, and the different wavelengths in the reference branch may be diffracted into different directions. Another portion of the broadband radiation may be used to irradiate (or illuminate) a sample. The sample may be a substrate comprising one or more metrology targets. Real-time wavelength-resolved beam profiling may contribute to improving the sample reconstruction by having improved beam profile data. Optionally, the total intensity of the diffracted radiation 806 is less than 10%, optionally 5%, of the total intensity of the radiation beam 804, such that majority of the radiation beam will radiate on the sample for metrology measurement with a big throughput.

Real-time as described herein may be understood to mean that the beam profile data is measured and generated in a time frame that allows feedback to the radiation source and/or metrology apparatus to make corrections to settings to fix measurement issues as they occur. As they occur may mean that under conventional operation the generated beam profile data is still relevant in the time it is provided to the metrology apparatus and/or radiation source. The apparatus as described herein may for example generate a wavelength-resolved beam profile in a range of seconds to minutes, e.g. 10 seconds to 5 minutes.

Sample reconstruction as described herein, may be based on the intensity distribution captured by a detector. The detector may be a high-order diffraction camera (HOD). The sample reconstruction may be based on pre-defined spot profiles. Spot profiles may be also be referred to herein as beam profiles. The spot profiles may be inherited from the original broadband radiation beam, which may be an SXR beam. In a simple approximation, the spot profiles may be approximated as Gaussian spots with a radiance corresponding to the average divergence of the beam. However, such a simple approximation may be insufficient for some applications, e.g. for high quality sample reconstruction. In reality, the spot profiles of the radiation beam may be wavelength dependent and non-Gaussian spot profiles. Furthermore, these beam profiles may be highly sensitive to even small aberrations in the drive laser generating the broadband radiation, wherein small aberrations may for example be of the order of 10mλ.

Reliable sample reconstruction may require accurate spot profile knowledge of the broadband radiation used for measuring the sample. As the beam profile may change over time (e.g. due to an error, drift of the metrology setup and/or source, component wear), real-time monitoring may provide an advantage of capturing these changes as they happen. Because the spot profiles may be sensitive changes in the drive radiation used to generate the broadband radiation, effects on the drive laser such as for example distortion of the drive laser focussing unit may result into a substantial change in the SXR radiation. Real-time monitoring may allow capturing such changes as they occur so that they can be addressed.

In some implementations, the color selector may comprise one or more moveable slits. The embodiments described below are about using one movable slit while the invention may be practised with multiple moveable slits, optionally working simultaneously. The slit may be moveable in at least one direction non-parallel to the propagation direction to the radiation beam. The slit may be moveable in two dimensions. The two dimensions may for example be perpendicular to the propagation direction of the radiation beam. The slit may be moveable in a three-dimensional space. The slit may for example be moved to overlap with a focal points of the different selected wavelengths. An advantage of using a slit (instead of an aperture) may be that it is may make it easier to select a wavelength because alignment of the slit to the radiation wavelength beam is only required in a single direction. The slit length may be long enough to capture the radiation beam without requiring specific alignment.

In some implementations, the color selector may comprise a moveable aperture. The aperture may be a circular aperture The aperture may be moveable in at least one direction non-parallel to the propagation direction to the radiation beam. The aperture may be moveable in two dimensions. The two dimensions may for example be perpendicular to the propagation direction of the radiation beam. The aperture may be moveable in a three-dimensional space. The aperture may for example be moved to overlap with a focal points of the different selected wavelengths. An advantage of using an aperture may be ease of analysis of any diffraction effects of the aperture (due to symmetry), and ease of production of the aperture.

In some implementations, the color selector may be apodised. The aperture/slit may be apodised so as to (partially) suppress diffraction caused by the aperture/slit. In some implementations, the radiation may be incident on the aperture/slit so that it does not illuminate the edge of the aperture/slit. This may also avoid diffraction caused by the aperture/slit. In one embodiment, the size of the aperture or the width of the slit is adjustable.

The radius of the aperture / the width of the slit may be of a size such that it allows the radiation spot profiles of the different wavelengths of the broadband radiation to pass. The radius of the aperture / width of the slit may also be small enough such that it avoids two neighbouring wavelength beam spots to pass through the slit/aperture at the same time. The aperture radius / slit width may be in a range of 15µm - 45µm, for example 30µm.

The color selector may comprise a set of mirrors. The mirrors may be planar mirrors and/or curved mirrors. The mirrors may be tilted relative to each other such that the radiation may hit the different mirrors at different angles. Different mirrors in the set may be configured to receive different wavelengths, and reflect them in different directions, such that they are incident on the detector. In some instances, the mirrors may be moveable to overlap with different diffracted wavelengths. Alternatively or additionally, the mirrors may be able to tilt relative to the diffracted radiation so as to change an incidence angle of the diffracted radiation, which in turn changes the reflection angle. In some implementations, the set of mirrors may receive multiple diffracted wavelengths on different mirrors of the set, simultaneously. In such instances, the mirrors may be configured to reflect different wavelengths to different locations on the detector(s), simultaneously, so that they may be measured simultaneously by the detector without overlap. An advantage of a setup using tilted mirrors is that it could enable measurement of multiple wavelengths (or in some cases all wavelengths of interest) of the broadband radiation.

The color selector may comprise a transmission grating. The transmission grating may be configured to move in one, two, or three dimensions as set out for the slit and aperture above, e.g. in order to select different parts of the diffracted radiation. The transmission grating may comprise adjustable slits, that is to say, the slits may have an adjustable width. The width of the slits may be adjusted to be optimised for diffracting the incident wavelength(s). The transmission grating may be configured to receive incident radiation and to generate an interference pattern of the received radiation. The interference pattern may be incident on the detector. Processing of the detected interference pattern may be required to determine a beam profile from the interference pattern. This processing may be performed by a processing unit included in and/or connected to the detector. In some instances, multiple diffraction orders (e.g. +1 and -1 diffraction orders) may be incident on the transmission grating to generate an interference pattern. In some instances, the interference pattern may be achieved from radiation from a single diffraction order.

The diffracted radiation may be spatially separated in a first plane. The first plane may be located in the far field from the diffracting element of the beam monitoring assembly. The first plane may be located in a focal plane of at least one of the diffracted radiation wavelengths. The color selector may be located in the first plane so that it can select different, spatially separated radiation having different wavelengths. The focal points for the different wavelengths of the diffracted radiation may vary such that they are not all located in the same plane and/or along a same line. It may be desirable for the color selector to be located in the focal plane of the radiation, or in a conjugate plane of the generation plane of the radiation. In some implementations therefore, the color selector may move in three dimensions such that it can move to the position of the focal point of each of the diffracted wavelengths. However, due to small divergence of the diffracted radiation, the focus depth of the diffracted radiation may be large, so that a single plane may be chosen that falls within the focus depth of some or all of the diffracted wavelengths. This plane may be selected as the first plane. If a conjugate plane of the generation plane is selected as the first plane, the spot of all wavelengths may be similar in size, which may be referred to as "effectively focussed", and may be a suitable plane for wavelength selection.

The beam monitoring assembly may comprise a focussing mirror system comprising a diffracting element. The focussing mirror system may comprise for example a toroidal mirror, or a set of mirrors tilted relative to each other. The diffracting element may be a diffraction grating present on the focussing mirror system. The diffraction grating may be configured to diffract a portion of the incident radiation beam to form the diffracted radiation. The diffracted radiation may be directed into a reference branch for beam profiling. In some implementations, the reference branch is located along the propagation path of the diffracted radiation. In some implementations, one or more optical elements may be provided to guide the diffracted radiation into the reference branch. The diffracted radiation for wavelength-resolved beam profiling may be understood to comprise at least one non-zeroth diffraction order. In some implementations, the diffracted radiation may comprise a single non-zero diffraction order for beam profiling (e.g. as illustrated in figure 8). In some implementations, the diffracted radiation may comprise two non-zero diffraction orders for beam profiling (e.g. in a setup according to figure 9 as described below). In some implementations, the diffracted radiation may comprise more than two diffraction orders for beam profiling.

The diffraction grating may introduce grating-induced high-order aberrations, e.g. caused by differences in grating response by different wavelengths. Beam monitoring can still be used to detect relative wavefront changes despite the aberrations.

In some implementations, the beam monitoring assembly may comprise a beam splitter. Optionally the beam splitter is a film/membrane. Optionally the beam splitter is a EUV pellicle. The beam splitter may be configured to receive the radiation beam intended for the metrology application, and to split off a portion of the received radiation beam to a diffraction grating. The diffraction grating may be located in the path of the split off radiation. The diffraction grating may generate the diffracted radiation for wavelength-resolved beam profiling.

The detector may be a camera configured to measure the shape and intensity of incident radiation. The detector may be located in the far field of the diffracted radiation. The detector may be configured to measure a beam profile of each selected wavelength as it is incident upon the detector. The measurements may form beam profile data which may be combined to determine and form a beam profile for the broadband radiation beam. The detector may comprise and/or be connected to one or more processors (with memory) for receiving and processing the beam profile data. The beam profile data may be provided to another apparatus. In a first example, wavelength-resolved beam profile data may be provided to the metrology apparatus. The metrology apparatus may use the beam profile data in combination with sample measurement data for determining a sample response (e.g. a metrology component of the sample measurement data related to the sample response). In another example wavelength-resolved beam profile data may be provided to the broadband radiation source, for example as feedback for making radiation beam adjustments.

The beam profile data may be obtained in a finite time scale. The time taken to obtain a wavelength dependent beam profile may depend on exposure time on the detector per wavelength, and on time needed for movement of the color selector to between different selected wavelengths. For example, it may take approximately 0.5s per detector exposure, and it may take approximately 1s to move the color selector from one selected wavelength to the next selected wavelength. The total amount of wavelengths to select may be for example around 50. This may lead to a measurement time of approximately 75s. These durations may be sped up for example providing a faster moving color selector stage and/or a higher power source. As the exposure time, moving time, and amount of wavelengths may all vary, the time scale for providing a "real-time" wavelength-resolved beam profile may be in a range of 10 seconds to 5 minutes, or 30 seconds to 2 minutes, or 60 seconds to 90 seconds. In some implementations, a wavelength-dependent beam profile may be measured continuously. That is to say, once a wavelength-dependent beam profile has been measured and generated, the next beam profile measurement may start. In some implementations, the wavelength-dependent beam profile measurements may be performed periodically, e.g. at set time intervals and/or triggered by events (e.g. change in another parameter such as pressure, temperature, etc.).

The beam profile data may be provided for real-time, or approximately real-time feedback by the apparatus. This may be possible as a result off the finite time scales in which the beam profile data is obtained and combined to form a wavelength-resolved beam profile for the broadband radiation.

The apparatus as described herein may form part of a system comprising elements as shown in figure 8. The system 820 may for example comprise a larger apparatus incorporating the apparatus 800 for wavelength-resolved beam profile determination. In some implementations, the system may comprise a broadband radiation source, configured to convert drive radiation to short-wavelength broadband radiation. In some implementations, the system may comprise an optical assembly configured to receive broadband radiation from an external source connected to the system. The system may further comprise at least one processor for receiving the beam profile data determined by the apparatus. The system may also comprise a memory (non-transitory storage medium) for storing the received beam profile data and/or any instructions. In some instances the processor(s) and/or memory may be separate from the system, and may be connected to the apparatus using a wired and/or wireless connection.

Figure 9 depicts a schematic representation of a system 900 for measuring one or more properties of a sample using broadband radiation as described herein. A radiation source 902 provides short-wavelength broadband radiation to a metrology setup 906 for measuring a sample. A portion of the short-wavelength radiation may be provided to apparatus 904 for wavelength-resolved beam profiling as described herein. The system may further comprise a processing unit comprising one or more processors and memory configured to receive beam profile data and/or metrology data.

In some implementations, the beam profile data may be provided for radiation source feedback. A processor (e.g. in processing unit 908) may determine one or more adjustments to one or more settings of the radiation source based on the beam profile data. Once determined, the adjustments may be provided to the radiation source. The adjustments may for example be based on current and/or historic beam profile data, such as for example changes in the beam profile data over time. The adjustments to the radiation source may lead to adjustments in the radiation beam. This may for example be done to tune the beam profile of the radiation beam. The beam profile tuning may comprise wavelength-resolved tuning of beam shape and intensity.

In some implementations to the processing unit may receive metrology data from the metrology setup 902. The processing unit may further receive the wavelength-resolved beam profile data from the apparatus 904. Both types of data may have been obtained from portions of the same radiation beam. The processing unit may determine a metrology component (e.g. a sample response) of the metrology data based on the metrology data in combination with the beam profile data. This may for example be done by determining a signature of the radiation beam based on the beam profile data, and removing (e.g. subtracting) the radiation beam signature from the metrology data. As stated above, the beam profile data is wavelength-resolved, therefore the signature and metrology components may also be wavelength resolved. This may lead to an improved determination of properties of the sample based on the metrology component, as beam-profile dependent effects may be removed.

The sample may be a lithographically patterned substrate. The properties to be measured on the sample may for example include one or more of overlay, levelling, and/or alignment of the sample.

In a specific implementation of wavelength-resolved beam profiling, for example as depicted in figure 8, the beam monitoring assembly 802 may comprise a grating configured to diffract a portion of received broadband radiation 804 into a separate branch for beam profiling. This separate branch may be referred to as a reference branch. Radiation not directed into the reference branch may be directed into an illumination branch for irradiation a sample for metrology. The beam monitoring assembly 802 may comprise a focussing mirror system with a diffraction grating located on it. The focussing mirror system may be configured to receive the broadband radiation and to reflect a portion into the illumination branch. The focussing mirror system may focus the radiation onto the sample for measuring properties of the sample. The focussing mirror system may be a toroidal illumination mirror.

In the reference branch of the beam profiling setup, the color selector may be located in an image plane of the diffracted radiation. The detector may be placed in the far field of the diffracted radiation (the far field being located beyond the color selector). By moving the color selector (e.g. an apodised slit), a single diffracted wavelength can be selected to pass through the selector. The selected wavelength will be incident onto the detector, which will detect the far-field beam profile of the selected wavelength. The measured beam profile may measure a shape of the beam profile. The detector may measure intensity distribution across the beam profile. The measured data may form a beam profile of the selected wavelength. Once the different wavelengths are separated it may also be possible to implement wavefront measurements per wavelength, using techniques e.g. Hartmann sensor, or ptychography mask.

The color selector may be moved so as to select each wavelength of interest in the diffracted broadband radiation. By moving the color selector through the image plane for the different wavelengths, the beam profiles for different wavelengths can be determined and combined to form wavelength-resolved beam profile data. The broadband radiation beam may have a wavelength-dependent focus length. As a result, the color selector may be configured to move in a direction parallel to the propagation direction of the radiation beam in the reference branch. However, due to the large focal depth of the radiation, it may be possible to select each wavelength in the same plane. An advantage of this may be a simplified alignment of the color selector.

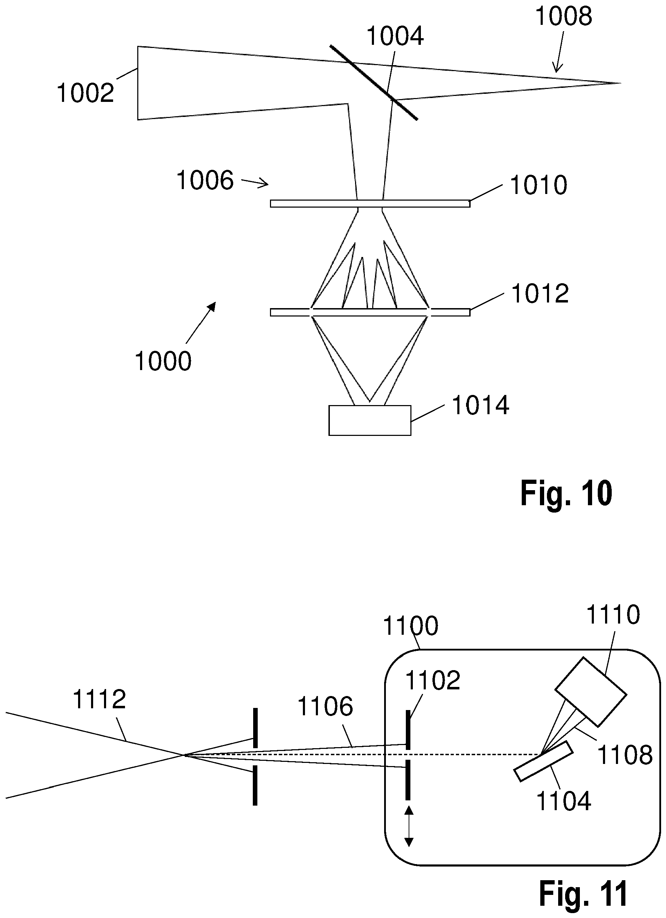

Figure 10 depicts a schematic representation of a specific implementation of a system and apparatus 1000 for wavelength-resolved beam profiling. Broadband radiation 1002 may be provided to a beam splitter 1004. The beam splitter may for example be a pellicle. The beam splitter 1004 may be configured to direct a portion of the radiation incident upon it to a reference branch 1006. The remainder of the radiation may be directed to an illumination branch 1008 for irradiating a sample, as described above. A diffractive element 1010, such as a transmission diffraction grating, may diffract the radiation in the transmission branch. In another embodiment, the diffractive element 1010 comprises a reflective diffraction grating. The beam splitter 1004 and diffractive element 1010 may form part of the beam monitoring assembly. A color selector 1012 and a detector 1014 may then select and detect different wavelengths of the diffracted broadband radiation as described above.

The color selector 1012 of the apparatus 1000 may comprise a slit, which may be an apodised slit. An advantage of the apparatus as shown in figure 10 may be that it is easier to use two diffraction order for beam profiling. For example a positive and negative non-zeroth diffraction order may both be incident on the color selector 1012. For example, the positive first +1 and negative first -1 diffraction orders may both be incident on a color selector. The color selector may cause an interference pattern of the diffracted radiation. For example the +1 and -1 diffraction order may cause an interference pattern. The color selector may be a transmission grating that may be moveable in one, two, or three dimensions for selecting different wavelengths as described above. The color selector may be a transmission grating with slits having adjustable widths. The width of the slits may be adjustable in order to tune it to the different wavelengths to be selected. The interference pattern may be measured by the detector and analysed by a processing unit to determine a beam profile. For example, the wavefront may be measured by means of shearing interferometry caused by a second transmission grating as a color selector. While this implementation of a color selector is described in relation to an apparatus as shown in figure 10, it is also possible to implement this solution in a setup as shown in figure 8 (e.g. using a focussing mirror system with a grating).

When discussing radiation wavelengths, no overlap may mean no overlap of the different peak wavelengths. The separation of wavelengths on the detector may be temporal (i.e. different wavelengths are measured at different points in time), and/or the separation may be spatial. The separation of all the measured wavelengths may be achieved through a combination of spatial and temporal separation, or through only one of the spatial or temporal separation.

The radiation may be generated through high harmonic generation of pump radiation. The pump radiation may for example be provided as longer wavelength laser radiation. The pump radiation may interact with a gas or solid medium to generate higher order radiation through nonlinear effects. The gas may for example comprise one or more noble gases (Neon, Argon, Krypton). The resulting broadband radiation beam may be provided for a metrology application, and a portion of the radiation beam may be separated for wavelength-resolved beam profiling as described herein. The short wavelength radiation may be generated in a large range of sizes, with beam waists of the order of a few µm (e.g. 1 µm) to multiple mm (e.g. 10 mm). In some implementations as described herein, the radiation beam to be resolved may have a diameter in a range from 20 µm to 50 µm at the location of the color selector. For example, at the location of the color selector, the radiation beam may have a diameter of approximately 40 µm. The diameter may be understood to be the 4σ width at the beam waist at this location. The location may be a conjugate plane of the generation plane of the radiation.

The broadband radiation may comprise short wavelength radiation, such as soft-X-ray (SXR) radiation. The broadband radiation for which beam profile data is to be determined may comprise two or more wavelengths in a range from 1 nm to 100 nm, 1 nm to 50 nm, 1 nm to 20 nm, 10 nm to 20 nm. For example for a broadband source using Neon, broadband radiation may comprise one or more wavelengths in a range from 7 nm - 20 nm, for a broadband source using Argon, broadband radiation may comprise one or more wavelengths in a range from 25 nm - 50 nm, a broadband source using Krypton, broadband radiation may comprise one or more wavelengths in a range from 30 nm - 55 nm.

Figure 11 depicts an apparatus 1100 with a moveable selector 1102 and a diffracting element 1104. The moveable selector selected is configured to receive a radiation beam 1106 comprising a plurality of wavelengths and to select a portion of the radiation beam. The diffracting element 1106 may be configured to receive at least some of the selection portion of the radiation beam incident upon it, and to diffract the incident radiation. The apparatus further comprises a detector 1110 configured to detect the diffracted radiation 1108 and to generate beam profile data of the selected radiation that has been detected. The apparatus as described in relation to figure 11 may have a selector that move through a beam in which colors are not spatially separated. The moveable selector may be one embodiment of the color selector as mentioned above. The beam may for example be a beam with the same or corresponding profile as the beam used for metrology, that is to say, not diffracted compared to the metrology radiation. As a result, the moveable selector may select portions of the beam comprising a plurality of wavelengths/colors instead of selected separated wavelengths/colors of the beam, as mentioned above.

The moveable selector may be configured to move through the beam (e.g. to scan through the beam) so that over time it selects every portion of the radiation beam. The different selected portions may be spatially separated portions of the beam. The selected portion may comprise radiations with multiple wavelengths. The moveable selector may be a slit or an aperture. The slit and the aperture may be apodised.

The detector may generate beam profile data for each selection portion of the radiation beam. The beam profile data may be provided so that a beam profile for the whole radiation beam can be constructed. By stitching together detected images, taken for different slit positions, beam profiles for different wavelengths can be reconstructed.

The apparatus 1100 may be provided as an apparatus 904 of a system 900 as described in relation to figure 9. The apparatus 1100 may be provided with or connected to a processing unit for processing the beam profile data and generating the beam profile for the entire radiation beam. Compared to the apparatus described for example in relation to figures 8 - 10, the apparatus 1100 depicted in figure 11 performs a selection step before a diffraction step. The apparatus 1100 may isolate (i.e. select) a narrow beam area and perform spectral decomposition of the selected narrow beam area. It may scan through the entire beam to select different narrow areas over time, so that after a scan of the full beam, the whole beam spectral decomposition can be reconstructed from the spectral decompositions of the different narrow beam areas. Narrow may be understood to mean smaller than the whole area of the beam, and with one dimension longer than the other. For example it may be an area which covers all or substantially all of one dimension of the beam, and a only a portion of the other dimension of the beam (e.g. a slit). It is possible to reconstruct wavelength resolved beam profiles based on the selected portions. The diffracting element may spatially separate different wavelengths in a selected radiation portion. The different wavelengths in each portion of selected radiation can be measured by the detector. The detected spots for the same wavelength may be recombined across the different selected portions. This may be used to reconstruct beam profiles for separate wavelengths.

An advantage of the setup described in relation to figure 11 may be that it provides a fast way of measuring the beam spectrum and/or wavelength-resolved beam profiles. Compared to the systems described in relation to figures 8 - 10, the alignment of the moveable selector is less dependent on the radiation beam composition.

The portion of the radiation beam selected by the moveable selector 1102 may comprise one or more of the plurality of wavelengths. The radiation beam may be broadband radiation as described herein. The radiation may comprise short wavelength radiation such as SXR radiation, as described herein. The broadband radiation 1106 may have been generated from pump radiation (e.g. infrared radiation) 1112.

Image alignment for different wavelengths may be done for example by means of a cross correlation function determining the overlap between two images. Numerically, it may be implemented as an inverse Fast Fourier Transform.

Alignment of the moveable selector to the radiation beam may be performed along an axis of the selector, e.g. along an axis of the slit. This alignment may be performed for example with the help of a crosshair to determine a center of the slit. A center of the slit may be aligned to a center of the diffracting element. The moveable selector may be configured to move along a first direction such that the entire beam circumference is selected by the moveable selector over time. The first direction may be in a plane perpendicular to a propagation direction of the beam. The diffracting element may comprise a diffraction grating on a mirror system. The diffracting element may be a reflective mirror with a grating. The diffracting element may be a transmissive/ transmission grating. In one embodiment, the transmission grating generates an interference pattern of the selected radiation, and the detector detects the interference pattern. The mirror system may be a focussing mirror system. The focussing mirror may be moved together with the slit for avoiding misalignment-caused aberrations. The detector may be a far field detector, and may be configured to perform far field spectroscopy.

The moveable selector may have a dimension (e.g. the slit may have a width) that is chosen so that the blurring caused by resonance broadening is reduced/minimized. For example, for wavelength ranges described herein (e.g. in a range of 10 nm - 20 nm), the width of the slit may be less than 50 µm in order to enable resolving side peaks. The width of the slit may be a resolution-limiting element of the apparatus 1100. Alternatively or additionally, the spectral resolution of the diffracting element may be a resolution-limiting element of the apparatus 1100.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. An apparatus comprising:
   a beam monitoring assembly configured to receive a radiation beam comprising a plurality of wavelengths, and to provide a diffracted radiation of the plurality of wavelengths, wherein each of the plurality of wavelengths is spatially separated in the diffracted radiation;
   a color selector configured to select a portion of the diffracted radiation; and
   a detector configured to detect the selected diffracted radiation and to generate beam profile data of the selected radiation;
   wherein the color selector is movable to select each of the plurality of diffracted wavelengths of the diffracted radiation such that the plurality of wavelengths do not overlap when incident on the detector.
2. An apparatus according to clause 1, wherein the color selector comprises a moveable slit.
3. An apparatus according to any of the preceding clauses, wherein the color selector comprises a moveable aperture.
4. An apparatus according to any of clauses 2 or 3, wherein the slit or aperture is apodised .
5. An apparatus according to any of the preceding clauses, wherein the color selector comprises a set of mirrors.
6. An apparatus according to clause 1, wherein the color selector comprises a transmission grating with width-adjustable slits.
7. An apparatus according to clause 6, wherein the transmission grating is movable.
8. An apparatus according to any of clauses 6-7, wherein the transmission grating generates an interference pattern of the selected radiation, and wherein the detector detects the interference pattern.
9. An apparatus according to any of the preceding clauses, wherein the diffracted wavelengths are spatially separated in a first plane, and wherein the color selector is located in the first plane.
10. An apparatus according to clause 9, wherein the color selector is configured to move in a single direction across the first plane.
11. An apparatus according to clause 9 or 10, wherein the first plane is a first focal plane of at least one wavelength of the diffracted radiation.
12. An apparatus according to clause 11, wherein the diffracted wavelengths have different focal points , and wherein the color selector moves along the different diffracted wavelengths focal points.
13. An apparatus according to any of the preceding clauses, wherein the beam monitoring assembly comprises a focussing mirror system comprising a diffraction grating, configured to diffract a portion of the incident radiation beam to form the diffracted radiation.
14. An apparatus according to any of clauses 1 - 12, wherein the beam monitoring assembly comprises a beam splitter configured to receive a radiation beam incident upon it, and to direct a portion of the radiation beam to a diffraction grating for generating diffracted radiation.
15. An apparatus according to any of the preceding clauses, wherein the detector is a camera configured to measure shape and intensity of incident radiation.
16. An apparatus according to any of the preceding clauses, wherein the detector is located in the far field of the diffracted radiation.
17. An apparatus according to any of the preceding clauses, wherein the diffracted radiation comprises one diffraction order.
18. An apparatus according to any of the preceding clauses, wherein the detector is configured to generate beam profile data of each of the plurality of diffracted wavelengths when it is detected by the detector, and to provide the beam profile data of the plurality of diffracted wavelengths to be combined to generate a beam profile of the radiation beam.
19. An apparatus according to any of the preceding clauses, wherein the beam profile data is detected during use of the radiation beam for a metrology application.
20. An apparatus according to any of the preceding clauses, wherein the beam profile data is configured to be generated in a time scale in a range of 10 seconds to 5 minutes, or 30 seconds to 2 minutes, or 60 seconds to 90 seconds, or 75 seconds.
21. An apparatus according to any of the preceding clauses, wherein the detector is configured to provide the beam profile data to a radiation source of the radiation beam for making radiation beam adjustments.
22. An apparatus according to any of the preceding clauses, wherein the detector is configured to provide the beam profile data to a metrology apparatus.
23. An apparatus according to any of the preceding clauses, wherein the radiation comprises radiation with wavelengths in a range from 1 nm - 100 nm, or 1 nm - 50 nm, or 1 nm - 20 nm, or 10 nm - 20 nm, or 1 nm to 10 nm.
24. An apparatus according to any of the preceding clauses, wherein the radiation comprises a radiation beam with a diameter in a range of 20 µm - 50 µm, such as 40µm.
25. A system comprising:
   an apparatus according to any of clauses 1 - 24;
   a radiation source configured to provide the radiation beam comprising a plurality of wavelengths to the apparatus; and
   a processor configured to receive beam profile data from the apparatus;
   wherein the processor is configured to determine adjustments to one or more settings of the radiation source, to make adjustments to the radiation beam.
26. A system according to clause 25, wherein the processor is further configured to:
   receive metrology data obtained using radiation from the radiation source; and
   determine a metrology component of the metrology data based on the metrology data in combination with the beam profile data
27. A system according to clause 26, wherein determining the metrology component comprises:
   determining a signature of the radiation beam based on the beam profile data; and
   subtracting the signature of the radiation beam from the metrology data to obtain the metrology component of the metrology data.
28. An apparatus comprising:
   a moveable selector configured to receive a radiation beam comprising a plurality of wavelengths, and to select a portion of the radiation beam;
   a diffracting element configured to receive at least some of the selected portion of the radiation beam incident upon it, and to diffract the incident radiation;
   a detector configured to detect the diffracted radiation and to generate beam profile data of the selected radiation.
29. An apparatus according to clause 28, wherein the moveable selector is configured to move through the radiation beam so as to select each portion of the radiation beam over time; and
   wherein the detector is configured to generate beam profile data for each selected portion of the radiation beam, and to provide the beam profile data of each selected portion for construction of a beam profile of the radiation beam.
30. An apparatus according to any of clauses 28 - 29, wherein the movable selector comprises a slit.
31. An apparatus according to clause 30, wherein a center of the slit is aligned to a center of the diffracting element.
32. An apparatus according to any of clauses 28 - 30, wherein the moveable selector is configured to move along a first direction such that the entire beam circumference is selected by the moveable selector over time.
33. An apparatus according to any of clauses 28 - 32, wherein the diffracting element comprises a diffraction grating on a mirror.
34. An apparatus according to any of clauses 28 - 33, wherein the radiation comprises soft-X-ray radiation.
35. A metrology apparatus comprising an apparatus according to any of clauses 1 - 34.
36. An inspection apparatus comprising an apparatus according to any of clauses 1 - 34.
37. A lithographic apparatus comprising an apparatus according to any of clauses 1 - 34.
38. A litho cell comprising an apparatus according to any of clauses 1 - 37.
39. An apparatus comprising:
   An optical element and a diffractive element configured to separate a branch beam from a multi-color beam into a branch, and to diffract the branch beam to generate multiple diffracted beams with different colours and propagation directions, wherein the apparatus are configured such that the multiple diffracted beams are focused at multiple medium focus points in the branch;
   A movable color selector configured to select multiple parts of the multiple diffracted beams at at least part of the multiple medium focus points to generate multiple detected beams with different wavelengths, and
   A detector configured to detect the multiple detected beams at far field and generate beam profiles of each of the multiple detected beams.
40. An apparatus according to clause 39, wherein the apparatus further comprises a processor configured to monitor the multi-color beam based on the generated beam profiles.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. An apparatus comprising:
a moveable selector configured to receive a radiation beam comprising a plurality of wavelengths, and to select a portion of the radiation beam;
a diffracting element configured to receive at least some of the selected portion of the radiation beam incident upon it, and to diffract the incident radiation;
a detector configured to detect the diffracted radiation and to generate beam profile data of the selected radiation.

2. An apparatus according to claim 1, wherein the moveable selector is configured to move through the radiation beam so as to select each portion of the radiation beam over time.

3. An apparatus according to claim 1 or 2, wherein the detector is configured to generate beam profile data for each selected portion of the radiation beam,

4. An apparatus according to claim 3, wherein the detector is configured to provide the beam profile data of each selected portion for construction of a beam profile of the radiation beam.

5. An apparatus according to any of the preceding claims, wherein the movable selector comprises a slit.

6. An apparatus according to claim 5, wherein a center of the slit is aligned to a center of the diffracting element.

7. An apparatus according to claim 5 or 6, wherein the slit is apodised.

8. An apparatus according to any of the preceding claims, wherein the moveable selector is configured to move along a first direction such that the entire beam circumference is selected by the moveable selector over time.

9. An apparatus according to any of the preceding claims, wherein the diffracting element comprises a diffraction grating on a mirror.

10. An apparatus according to any of the preceding claims, wherein the diffracting element comprises a transmission grating.

11. An apparatus according to claim 5, wherein the transmission grating generates an interference pattern of selected portion of the radiation beam, and the detector detects the interference pattern.

12. An apparatus according to any of the preceding claims, wherein the selected portion of the radiation beam comprises radiation with multiple wavelengths.

13. A metrology apparatus comprising an apparatus according to any of claims 1 - 12.

14. A lithographic apparatus comprising an apparatus according to any of claims 1 - 12.

15. A litho cell comprising an apparatus according to any of claims 1 - 14.
